# EUROPEAN PATENT APPLICATION

(11) **EP 1 983 499 A1**
(43) Date of publication of application: **22.10.2008**
(21) Application number: 07706834.4
(22) Date of filing: 16.01.2007
(51) Int. Cl.: G09F 9/30, G02F 1/1368, H01L 21/336, H01L 29/786

(54) **REFLECTIVE TFT SUBSTRATE AND METHOD FOR MANUFACTURING REFLECTIVE TFT SUBSTRATE**

(30) Priority: 09.02.2006 JP 2006031833
(71) Applicant: Idemitsu Kosan Co., Ltd., Chiyoda-ku Tokyo 100-8321 (JP)
(72) Inventor: INOUE, Kazuyoshi, Chiba 299-0293 (JP); YANO, Koki, Chiba 299-0293 (JP); TANAKA, Nobuo, Chiba 299-0293 (JP)
(74) Representative: Gille Hrabal Struck Neidlein Prop Roos
(86) International application number: PCT/JP2007/050507
(87) International publication number: WO 2007/091405

(57) **Abstract**

A reflective TFT substrate which can be operated for a prolonged period of time due to the presence of a protective insulating film, is free from occurrence of crosstalk, and is capable of significantly reducing manufacturing cost by decreasing the production steps in the production process. A reflective TFT substrate 1 comprises a substrate 10; a gate electrode 23 and a gate wire 24; a gate insulating film 30; an n-type oxide semiconductor layer 40; a metal layer 60 formed with a channel part 41 interposed therebetween; and a protective insulating film 80 which covers the upper part of the glass substrate 10 on which a pixel electrode 67, a drain wire pad 68 and a gate wire pad 25 are exposed, wherein the metal layer 60 functions at least as a source wire 65, a drain wire 66, a source electrode 63, a drain electrode 64 and the pixel electrode 67.

## Description

### TECHNICAL FIELD

The invention relates to a reflective TFT substrate and a method for producing a reflective TFT substrate. In particular, the reflective TFT substrate of the invention comprises an oxide semiconductor layer, a metal layer and a protective insulating film. The oxide semiconductor layer is an active layer of a TFT (Thin Film Transistor). The metal layer is formed above the oxide semiconductor layer with a channel part interposed therebetween, and functions as a source wire, a drain wire, a source electrode, a drain electrode and a pixel electrode. Due to such a configuration, the reflective TFT substrate of the invention can be operated stably for a prolonged period of time. In addition, according to the invention, not only manufacturing cost can be decreased due to the reduction of production steps but also concern for occurrence of interference of gate wires (crosstalk) can be eliminated.

### BACKGROUND

LCD (Liquid Crystal Display) apparatuses or organic EL display apparatuses are widely used due to their display performance, energy saving properties, and for other such reasons. These display apparatuses constitute nearly all of the mainstreams of display apparatuses, in particular, display apparatuses in cellular phones, PDAs (personal digital assistants), PCs, laptop PCs, and TVs. Generally, TFT substrates (including reflective TFT substrates) are used in these display apparatuses.

For instance, in liquid crystal display apparatuses, display materials such as a liquid crystal are filled between a TFT substrate and an opposing substrate. In these display materials, a voltage is selectively applied to each pixel. Here, a "TFT substrate" means a substrate on which a TFT (Thin Film Transistor) composed of a semiconductor thin film (also called "semiconductor film") or the like is arranged. Generally, a TFT substrate is referred to as a "TFT array substrate" since TFTs are arranged in an array.

On a TFT substrate which is used in a liquid crystal display apparatus and so on, "sets" (a set includes a TFT and one pixel of the screen of a liquid crystal display apparatus, called "one unit") are arranged vertically and laterally on a glass substrate. In a TFT substrate, for example, gate wires are arranged at an equal interval in the vertical direction on a glass substrate, and either source wires or drain wires are arranged at an equal interval in the lateral direction. The other of the source wire and the drain wire, a gate electrode, a source electrode and a drain electrode are provided respectively in the above-mentioned unit constituting each pixel.

### <Conventional method for producing TFT substrate>

As the method for producing a TFT substrate, a 5-mask process using five masks, a 4-mask process using four masks by half-tone exposure technology, and other processes are known.
In such a method for producing a TFT substrate, the production process needs many steps since five or four masks are used. For example, the 4-mask process requires 35 steps and the 5-mask process requires steps exceeding 40. So many production steps may decrease production yield. In addition, many steps may make production process complicated and also increase manufacturing cost.

### (Method for production using five masks)

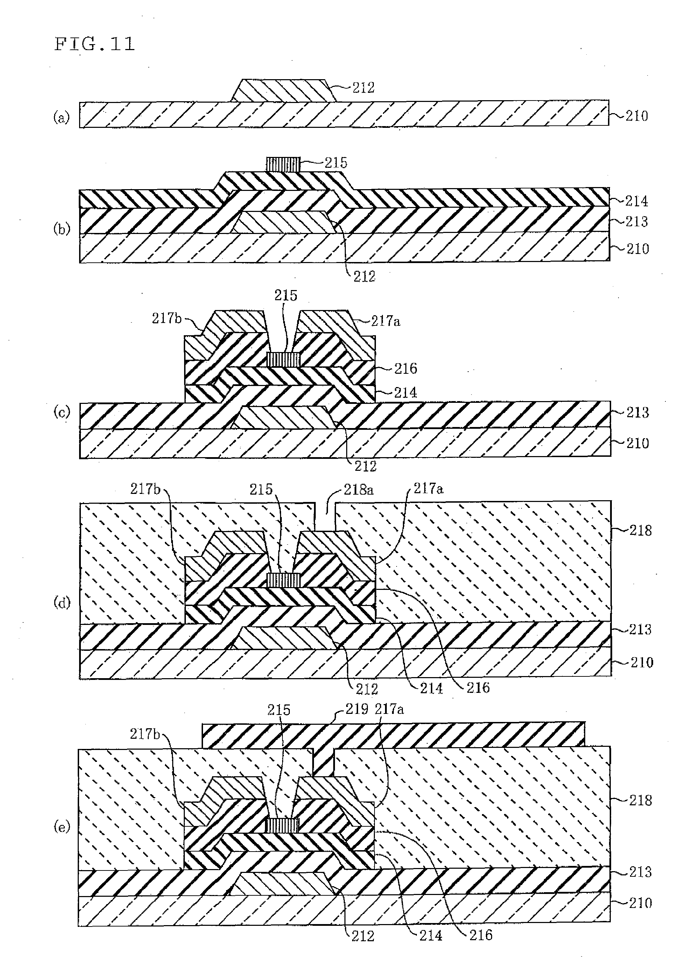

FIG. 11 is schematic views for explaining the conventional method for producing a TFT substrate. (a) is a cross-sectional view after the formation of a gate electrode. (b) is a cross-sectional view after the formation of an etch stopper. (c) is a cross-sectional view after the formation of a source electrode and a drain electrode. (d) is a cross-sectional view after the formation of an interlayer insulating film. (e) is a cross-sectional view after the formation of a pixel electrode.
In FIG. 11(a), a gate electrode 212 is formed on a glass substrate 210 by using a first mask (not shown). That is, first, a metal (such as aluminum (Al)) is deposited on the glass substrate 210 by sputtering. Then, a resist is formed by photolithography by using the first mask. Subsequently, the metal film is formed into a predetermined shape by patterning with an etching method to form the gate electrode 212, and the resist is removed through an ashing process.

Next, as shown in FIG. 11 (b), on the glass substrate 210 and the gate electrode 212, a gate insulating film 213 formed of an SiN film (silicon nitride film) and an α-Si:H(i) film 214 are stacked in this order. Subsequently, an SiN film (silicon nitride film) as a channel protective layer is deposited. Then, a resist is formed by photolithography using a second mask (not shown). Then, the SiN film is patterned into a predetermined shape with a dry etching method using a CHF gas, an etch stopper 215 is formed, and the resist is removed through an ashing process.

Next, as shown in FIG. 11(c), an α-Si:H(n) film 216 is deposited on the α-Si:H (i) film 214 and the etch stopper 215. Then, a Cr (chromium) /Al double-layer film is deposited thereon by vacuum deposition or sputtering. Subsequently, a resist is formed by photolithography using a third mask (not shown). Then, the Cr/Al double-layer film is patterned with an etching method, whereby a source electrode 217a and a drain electrode 217b are formed into a predetermined shape. In this case, Al is patterned with a photo-etching method using H₃PO₄-CH₃COOH-HNO₃ and Cr is patterned with a photo-etching method using an aqueous solution of diammonium cerium nitrate. Subsequently, the α-Si:H films (216 and 214) are patterned by a dry etching method using a CHF gas and by a wet etching method using an aqueous hydrazine solution (NH₂NH₂·H_{2O}), whereby the α-Si:H (n) film 216 and the α-Si:H (i) film 214 are formed into predetermined shapes, and the resist is removed through an ashing process.

Then, as shown in FIG. 11(d), before forming a transparent electrode 219, an interlayer insulating film 218 is deposited on the gate insulating electrode 213, the etch stopper 215, the source electrode 217a and the drain electrode 217b. Subsequently, a resist is formed by photolithography using a fourth mask (not shown). Then, the interlayer insulating film 218 is patterned with an etching method, a through hole 218a for electrically connecting the transparent electrode 219 with the source electrode 217a is formed, and the resist is removed through an ashing process.

Next, as shown in FIG. 11(e), on the interlayer insulating film 218 in a region where patterns of the source electrode 217a and the drain electrode 217b are formed, an amorphous transparent conductive film formed mainly of indium oxide and zinc oxide is deposited by sputtering. Subsequently, a resist is formed by photolithography by using a fifth mask (not shown) . Then, the amorphous transparent conductive film is patterned with a photo-etching method using an approximately 4 wt% aqueous solution of oxalic acid as an etchant. Then, the amorphous transparent conductive film is formed into such a shape that the film electrically contacts the source electrode 217a and the resist is removed through an ashing process. As a result, the transparent electrode 219 is formed.
As mentioned above, five masks are required in the conventional method for producing a TFT substrate.

### (Method for production using three masks)

To improve the above-mentioned conventional technology, various technologies to produce a TFT substrate by a method in which production steps are further reduced by decreasing the number of masks (from five to three, for example) have been proposed. For example, the following patent documents 1 to 7 describe a method of producing a TFT substrate using three masks.
Patent Document 1: JP-A-2004-317685
Patent Document 2: JP-A-2004-319655
Patent Document 3: JP-A-2005-017669
Patent Document 4: JP-A-2005-019664
Patent Document 5: JP-A-2005-049667
Patent Document 6: JP-A-2005-106881
Patent Document 7: JP-A-2005-108912

### DISCLOSURE OF THE INVENTION

### Problem to be Solved by the Invention

However, the methods for producing a TFT substrate using three masks described in the above-mentioned patent documents 1 to 7 require an anodic oxidation step or the like of a gate insulating film, and hence, they are very complicated. Therefore, there is a problem that the above methods for producing a TFT substrate are difficult to put into practical use.
Furthermore, in the actual production line, quality (for example, long-term stable operability or elimination of disadvantages such as interference of gate wires (crosstalk)) is important. That is, a practical technique capable of improving not only quality but also productivity has been desired.
In addition, improvement of quality or productivity has been demanded also for a reflective TFT substrate.

The invention has been made in view of the above-mentioned problem, and an object thereof is to provide a reflective TFT substrate capable of being operated for a prolonged period of time due to the presence of a channel guard, free from occurrence of crosstalk, and can be produced at a significantly reduced manufacturing cost due to reduced production steps in the production process, as well as a method for producing such a reflective TFT substrates.

### Means for Solving the Problem

To achieve the above-mentioned object, a reflective TFT substrate of the invention comprises: a substrate; a gate electrode and a gate wire formed above the substrate; a gate insulating film formed above the substrate, the gate electrode and the gate wire; an oxide layer formed above the gate electrode, and above the gate insulating film; a metal layer formed above the oxide layer with a channel part interposed therebetween; and a pixel electrode which electrically contacts a source/drain electrode, wherein the metal layer functions at least as the pixel electrode and the source/drain electrode which contacts the pixel electrode.
Due to such a configuration, the number of masks used during the production can be decreased, leading to the reduction of production steps. As a result, production efficiency can be improved and manufacturing cost can be reduced. Usually, the source wire, the drain wire, the source electrode, the drain electrode and the pixel electrode are formed of the metal layer. By doing this, the source wire, the drain wire, the source electrode, the drain electrode and the pixel electrode can be produced efficiently. Further, the electric resistance of each wire or each electrode can be decreased, whereby reliability can be improved and a decrease in energy efficiency can be suppressed.

In addition, it is preferred that an oxide conductor layer be formed between the oxide layer and the metal layer.
By doing this, switching speed of a TFT can be increased, and durability of a TFT can be improved.

Further, it is preferred that the metal layer have a reflectance of 80% or more.
By doing this, a reflective TFT substrate improved in luminance can be provided.

Further, it is preferred that the metal layer be formed of a thin film composed of aluminum, silver or gold or an alloy layer containing aluminum, silver or gold.
Due to such a configuration, a larger amount of light can be reflected, whereby the luminance by the reflected light can be improved.

In addition, it is preferred that the reflective TFT substrate be provided with a metal layer and/or a metal thin film, and that the reflective TFT substrate have a metal layer-protecting oxide transparent conductor layer for protecting the metal layer and/or the metal thin film.
By doing this, not only the metal layer/the metal thin film can be prevented from corrosion but also the durability thereof can be improved. For example, if the metal thin film is used as the gate wire, the metal surface can be prevented from being exposed when an opening for a gate wire pad is formed, whereby connection reliability can be improved. Further, if the metal layer is a reflective metal layer, discoloration or other problems can be prevented, and disadvantages such as a decrease in reflectance of the reflective metal layer can be prevented. In addition, since the metal layer-protecting oxide transparent conductor layer is rendered transparent, the amount of transmitted light is not decreased. As a result, a display apparatus improved in luminance can be provided.

Further, it is preferred that the upper part of the reflective TFT substrate be covered with a protective insulating film, and that the protective insulating film have openings corresponding to each of the pixel electrode, a source/drain wire pad and a gate wire pad.
Due to such a configuration, the upper part of the oxide layer constituting the channel part is protected by the protective insulating film, and a TFT can be operated stably for a prolonged period of time. Since the reflective TFT substrate is provided with the protective insulating film, it is possible to provide a reflective TFT substrate capable of producing easily a display means or an emitting means utilizing a liquid crystal, an organic EL material or the like.
Here, the source/drain wire pad means a source wire pad or a drain wire pad.

Further, it is preferred that the oxide layer be an n-type oxide semiconductor layer.
As is apparent from the above, by using the oxide semiconductor layer as an active layer of a TFT, a TFT remains stable when electric current is flown. Therefore, the reflective TFT substrate is advantageously used for an organic EL apparatus which is operated under current control mode.

Further, it is preferred that the oxide layer be formed at positions corresponding to the channel part, a source wire, a drain wire, a source electrode, a drain electrode and the pixel electrode.
By doing this, since the oxide layer is formed only at the predetermined positions, concern for occurrence of interference of the gate wires (crosstalk) can be eliminated.

Further, it is preferred that the oxide layer have an energy gap of about 3.0 eV or more.
By rendering the energy gap 3.0 eV or more, malfunction caused by light can be prevented. Normally, the energy gap may be about 3.0 eV or more, but preferably the energy gap may be about 3.2 eV or more, more preferably about 3.4 eV or more. By rendering the energy gap large, prevention of malfunction caused by light can be ensured. If the reflective TFT substrate is provided with the oxide conductor layer, the oxide conductor layer may have an energy gap of about 3.0 eV or more. By doing this, similar effects can be obtained.

To achieve the above-mentioned object, the method for producing a reflective TFT substrate of the invention comprises the steps of: forming a gate electrode and a gate wire above a substrate by using a first mask; stacking a gate insulating film, an oxide layer, a metal layer and a second resist above the substrate, the gate electrode and the gate wire, and forming the second resist into a predetermined shape by half-tone exposure; patterning the metal layer and the oxide layer by an etching method using the second resist to form a source wire, a drain wire and a pixel electrode; after reforming the second resist, selectively patterning the metal layer above the gate electrode by an etching method using the reformed second resist to form a source electrode and a drain electrode; stacking a protective insulating film and a third resist above the gate insulating film and the oxide layer, which are exposed, as well as above the source wire, the drain wire, the source electrode, the drain electrode and the pixel electrode; and forming the third resist into a predetermined shape by using a third mask; and patterning the protective insulating film above the pixel electrode and a source/drain wire pad, as well as the protective insulating film and the gate insulating film above a gate wire pad by an etching method using the third resist to expose the pixel electrode, the source/drain wire pad and the gate wire pad.
As is apparent from the above, the invention is advantageous also as a method for producing a reflective TFT substrate, and a reflective TFT substrate can be produced by using three masks. Since the number of masks is decreased and production steps are reduced, production efficiency can be improved and manufacturing cost can be decreased. Moreover, since the upper part of the oxide layer constituting the channel part is protected by the protective insulating film, the reflective TFT substrate can be operated stably for a prolonged period of time. Further, since the oxide layer is normally formed only at predetermined positions (predetermined positions corresponding to the channel part, the source wire, the drain wire the source electrode, the drain electrode and the pixel electrode), concern for occurrence of interference between the gate wires (crosstalk) can be eliminated.

Further, it is preferred that an oxide conductor layer be formed between the oxide layer and the metal layer.
By doing this, switching speed of a TFT can be increased, and durability of a TFT can be improved.

Further, it is preferred that a metal layer-protecting oxide transparent conductor layer be stacked above the metal layer.
By doing this, not only the metal layer can be prevented from corrosion but also the durability thereof can be improved. For example, if the metal layer is a reflective metal layer, discoloration or other problems of the reflective metal layer can be prevented, and disadvantages such as a decrease in reflectance of the reflective metal layer can be prevented.

Further, it is preferred that a metal layer-protecting oxide transparent conductor layer be stacked above the gate electrode and the gate wire.
By doing this, for example, if a metal layer is used as the gate wire, the metal surface can be prevented from being exposed when an opening for a gate wire pad is formed, whereby connection reliability can be improved.

### BRIEF DESCRIPTION OF THE DRAWINGS

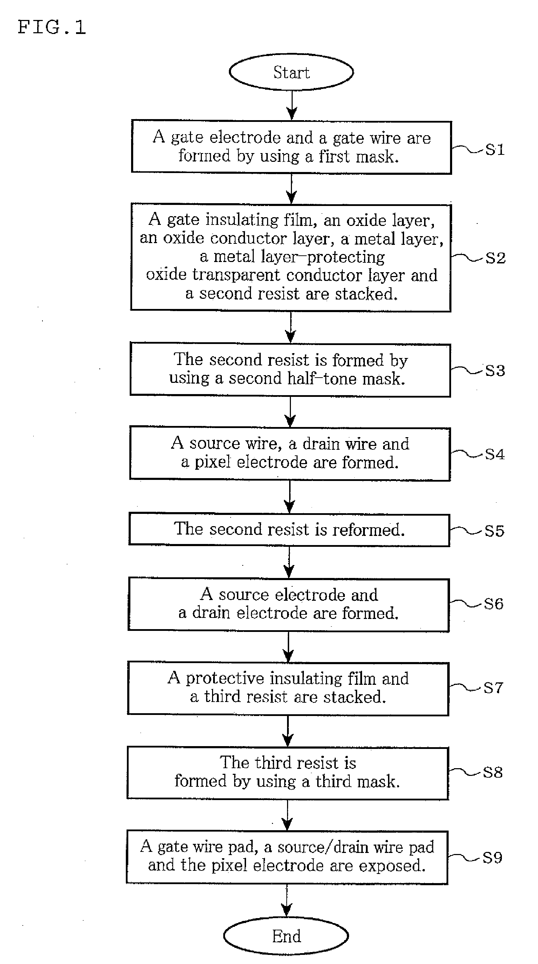

FIG. 1 is a schematic flow chart for explaining the method for producing a reflective TFT substrate according to one embodiment of the invention;

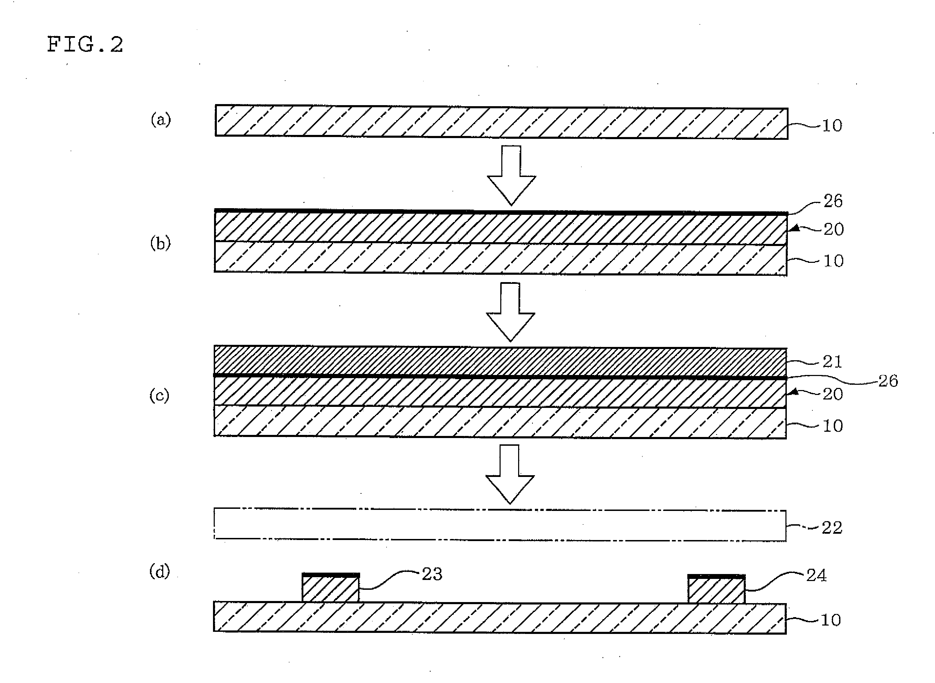

FIG. 2 is a schematic view for explaining treatment using a first mask in the method for producing a reflective TFT substrate according to one embodiment of the invention; in which (a) is a cross-sectional view of a glass substrate before treatment; (b) is a cross-sectional view after the formation of a metal layer/the formation of a metal layer-protecting oxide transparent conductor layer; (c) is a cross-sectional view after the application of a first resist; and (d) is a cross-sectional view after exposure/development/first etching and peeling off the first resist, showing the formation of a gate electrode and a gate wire;

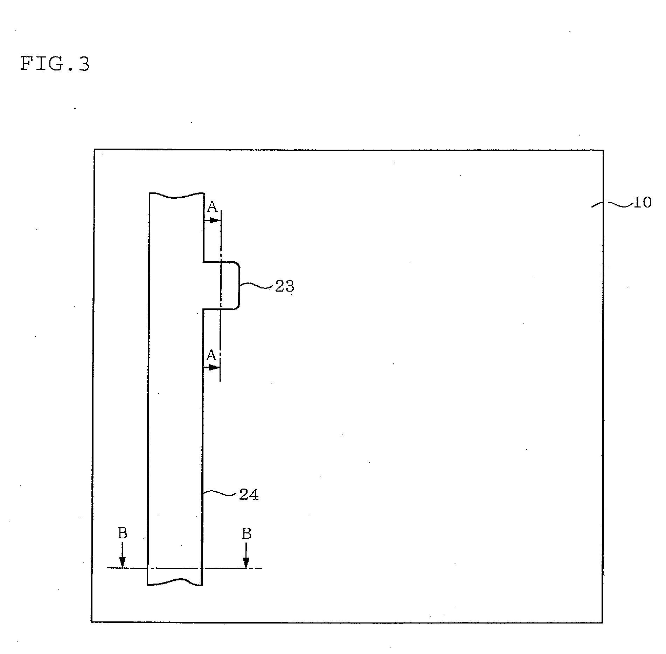

FIG. 3 is a schematic plan view of an essential part of a glass substrate in which a gate electrode and a gate wire are formed in the method for producing a reflective TFT substrate according to one embodiment of the invention;

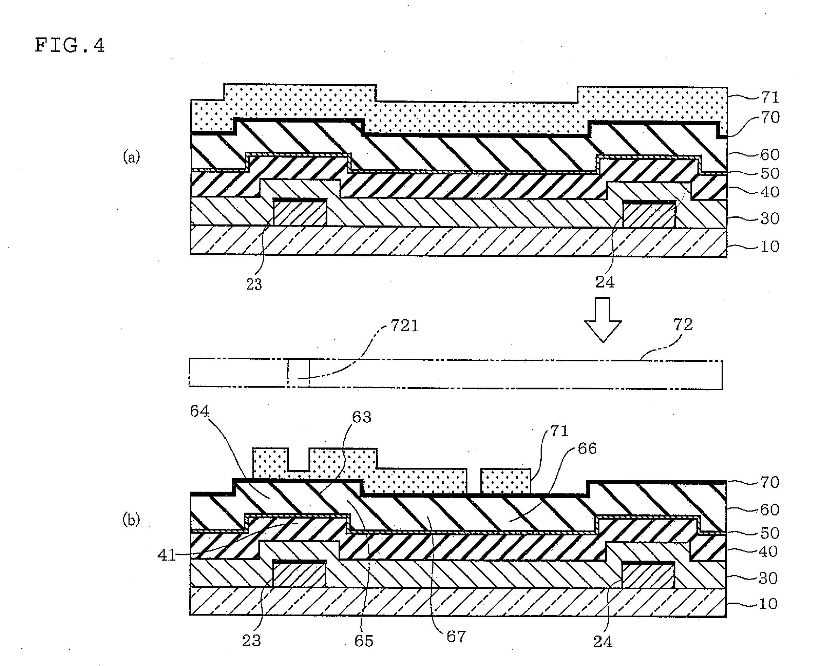

FIG. 4 is a schematic view for explaining treatment using a second half-tone mask in the method for producing a reflective TFT substrate according to one embodiment of the invention, in which (a) is a cross-sectional view after the formation of a gate insulating film/after the formation of an n-type oxide semiconductor layer/after the formation of an oxide conductor layer/after the formation of a metal layer/after the formation of a metal layer-protecting oxide transparent conductor layer/after the application of a second resist; and (b) is a cross-sectional view after half-tone exposure/development;

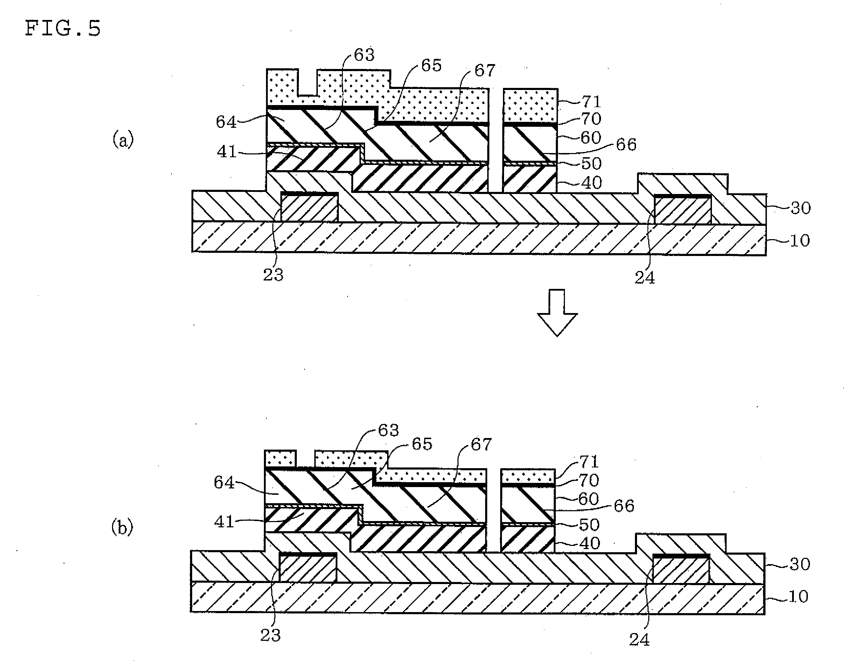

FIG. 5 is a schematic view for explaining treatment using a second half-tone mask in the method for producing a reflective TFT substrate according to one embodiment of the invention, in which (a) is a cross-sectional view after second etching; and (b) is a cross-sectional view after reformation of a second resist;

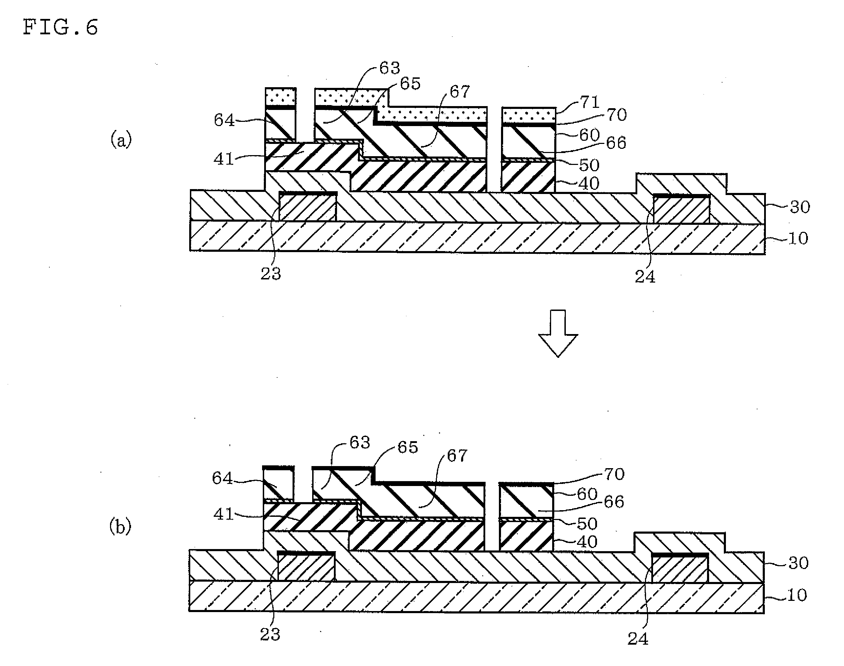

FIG. 6 is a schematic view for explaining treatment using a second half-tone mask in the method for producing a reflective TFT substrate according to one embodiment of the invention, in which (a) is a cross-sectional view after third etching; and (b) is a cross-sectional view after peeling off of a second resist;

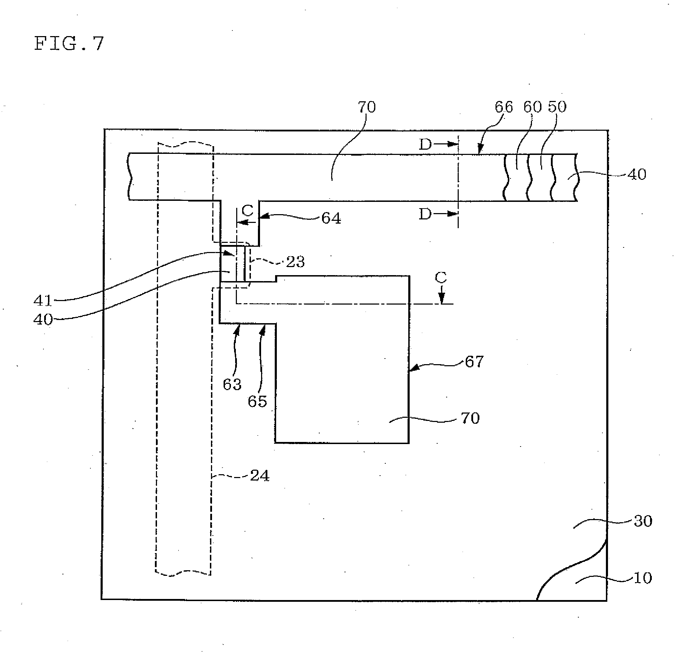

FIG. 7 is a schematic plan view of an essential part of a glass substrate in the method for producing a reflective TFT substrate according to one embodiment of the invention, in which a metal layer-protecting oxide transparent conductor layer above a source electrode, a drain electrode, a source wire, a drain wire and a pixel electrode is exposed;

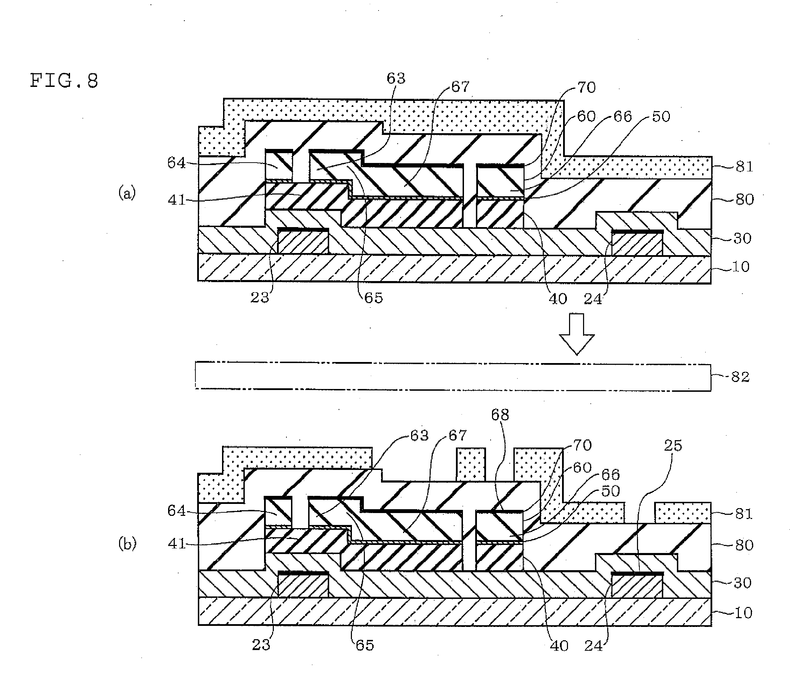

FIG. 8 is a schematic view for explaining treatment using a third mask in the method for producing a reflective TFT substrate according to one embodiment of the invention, in which (a) is a cross-sectional view after the formation of a protective insulating film/the application of a third resist; and (b) is a cross-sectional view after exposure/development;

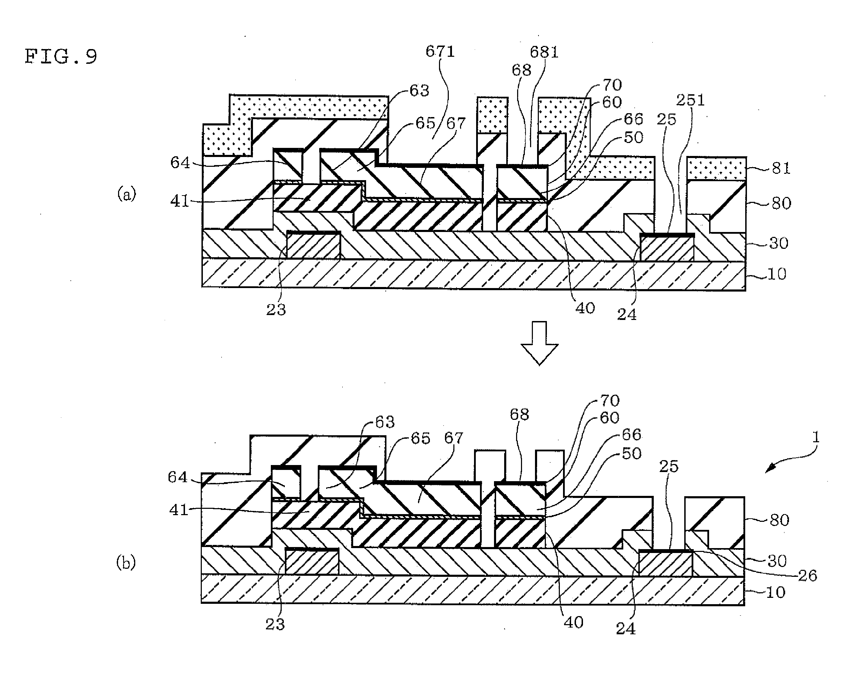

FIG. 9 is a schematic view for explaining treatment using a third mask in the method for producing a reflective TFT substrate according to one embodiment of the invention, in which (a) is a cross-sectional view after fourth etching; and (b) is a cross-sectional view after peeling off of a third resist;

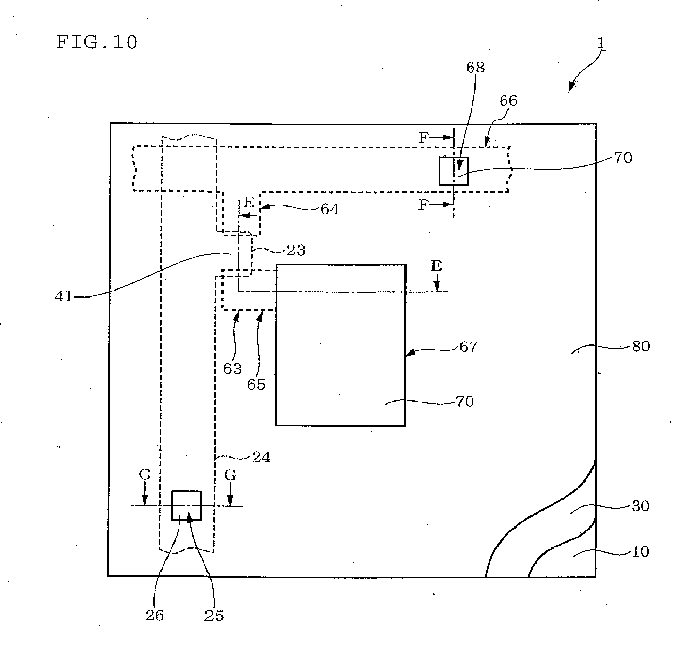

FIG. 10 is a cross-sectional view of an essential part of a glass substrate in the method for producing a reflective TFT substrate according to one embodiment of the invention, in which a protective insulating film is exposed; and
FIG. 11 is a schematic view for explaining the conventional method for producing a TFT substrate, in which (a) is a cross-sectional view after formation of a gate electrode; (b) is a cross-sectional view after the formation of an etch stopper; (c) is a cross-sectional view after the formation of a source electrode and a drain electrode; (d) is a cross-sectional view after the formation of an interlayer insulating film; and (e) is a cross-sectional view after the formation of a transparent electrode.

### BEST MODE FOR CARRYING OUT THE INVENTION

### [One embodiment of the method for producing a reflective TFT substrate]

FIG. 1 is a schematic flow chart for explaining the method for producing a reflective TFT substrate according to one embodiment of the invention.
In FIG. 1, first, a gate electrode 21 and a gate wire 22 are formed on a substrate 10 by using a first mask 22 (Step S1).
Then, treatment using the first mask 22 will be explained with reference to the drawing.

### (Treatment using a first mask)

FIG. 2 is a schematic view for explaining treatment using a first mask in the method for producing a reflective TFT substrate according to one embodiment of the invention. (a) is a cross-sectional view of a glass substrate before treatment. (b) is a cross-sectional view after the formation of a metal layer/the formation of a metal layer-protecting oxide transparent conductor layer. (c) is a cross-sectional view after the application of a first resist. (d) is a cross-sectional view after exposure/development/first etching and peeling off the first resist, showing the formation of a gate electrode and a gate wire.
In FIG. 2(a), a light-transmissive glass substrate 10 is provided at first.
A plate-like element as the base material of the reflective TFT substrate 1 is not limited to the above-mentioned glass substrate 10. For example, a plate- or sheet-like element made of a resin may be used. The glass substrate 10 is not limited to the light-transmissive glass substrate 10. For example, a light-shielding or semitransparent glass substrate may be used.

Then, as shown in FIG. 2(b), a metal layer is formed on the glass substrate 10, whereby a thin film for a gate electrode/a gate wire (a gate electrode and a gate wire) 20 is formed.
In this embodiment, on the glass substrate 10, Al and Mo are deposited in this order by using the high-frequency sputtering method to form a metal thin film with a thickness of about 250 nm and a metal thin film with a thickness of about 50 nm, respectively. Subsequently, using an indium oxide-zinc oxide (generally called IZO; In₂O₃:ZnO=about 90:10 wt%) sputtering target, a metal layer-protecting oxide transparent conductor layer (hereinafter occasionally abbreviated as an oxide protecting film) 26 is formed in a thickness of about 100 nm, whereby a thin film for a gate electrode/a gate wire 20 composed of an Al layer, an Mo layer and an IZO layer is formed.
Meanwhile, the Mo layer on the Al layer is used in order to decrease contact resistance with the oxide protecting film. Therefore, if the contact resistance is negligibly low, the Mo layer may not necessarily be formed. Instead of Mo, Ti (titanium), Ni (nickel), Cr (chromium) or the like may be used. Further, as the gate wire, a thin film of a metal such as Ag (silver) and Cu (copper) or a thin film of an alloy thereof may be used.

A transparent conducive film such as an IZO film is arranged on the surface of the gate wire 24 as the metal layer-protecting oxide transparent conductor layer 26. As a result, the surface of a metal used in the gate wire 24 is prevented from being exposed when forming an opening 251 in a gate insulating film 30 to form a gate wire pad 25, leading to improved connection reliability.
In addition, an insulating product such as SiNₓ, SiONₓ and SiO₂ is used as the gate insulating film 30 and the opening 251 is formed in the gate insulating film 30 by the reactive ion etching method by using CHF (CF₄, CHF₃ or the like). In such a case, a transparent conductive film such as an IZO film serves as a protective film of the metal layer (Al/Mo layer).

As a material replacing IZO, a material obtained by incorporating into ITO a lanthanoide-based element or a material obtained by adding to ITO an oxide of a high-melting-point metal such as Mo or W can be used. Here, a preferable added amount is about 30 at.% or less, more preferably about 1 to 20 at.%, relative to total metal elements. If the added amount exceeds about 30 at.%, the etching rate in an aqueous oxalic acid solution or an acid mixture composed of phosphoric acid, acetic acid and nitric acid (hereinafter occasionally abbreviated as acid mixture) may be lowered. The film thickness may preferably be about 20 nm to 500 nm. It is more preferred that the thickness be about 30 nm to 300 nm. If the thickness is less than about 20 nm, the filmmay have pinholes and cannot function as a protective film. On the other hand, if the film thickness exceeds approximately 500 nm, film formation or etching takes a lot of time, leading to an economical disadvantage.

Then, as shown in FIG. 2(c), a first resist 21 is applied on the thin film for a gate electrode/a gate wire 20.

Then, as shown in FIG. 2(d), by using the first mask 22, the resist (not shown) is formed into a predetermined shape by photolithography. Subsequently, the metal layer-protecting oxide transparent conductor layer 26 is patterned with an etching method using an aqueous oxalic acid solution. Further, the metal thin film is patterned with an etching method using an acid mixture (generally called PAN), whereby the gate electrode 23 and the gate wire 24 are formed into desired shapes (see FIG. 3). The gate electrode 23 and the gate wire 24 shown in FIG. 2(d) are a cross-sectional view taken along line A-A and a cross-sectional view taken along line B-B in FIG.3, respectively. Here, IZO can be etched with PAN. Therefore, the metal layer-protecting oxide transparent conductor layer 26 and the metal thin film may be etched simultaneously using the above-mentioned PAN.

Then, as shown in FIG. 1, a gate insulating film 30, an n-type oxide semiconductor layer 40 as an oxide layer, an oxide conductor layer 50, a metal layer 60, a metal layer-protecting oxide transparent conductor layer 70 and a second resist 71 are stacked in this order on the glass substrate 10, the gate electrode 23 and the gate wire 24 (Step S2). Subsequently, the second resist 71 is formed into a predetermined shape with the second half-tone mask 72 by half-tone exposure (Step S3).
Next, treatment using the second half-tone mask 72 will be explained with reference to the drawing.

### (Treatment using a second half-tone mask)

FIG. 4 is a schematic view for explaining treatment using a second half-tone mask in the method for producing a reflective TFT substrate according to one embodiment of the invention, in which (a) is a cross-sectional view after the formation of a gate insulating film/after the formation of an n-type oxide semiconductor layer/after the formation of an oxide conductor layer/after the formation of a metal layer/after the formation of a metal layer-protecting oxide transparent conductor layer/after the application of a second resist; and (b) is a cross-sectional view after half-tone exposure/development.
In FIG. 4 (a), a gate insulating film 30, which is a silicon nitride (SiNₓ) film, is deposited in a thickness of about 300 nm by the glow discharge CVD (Chemical Vapor Deposition) method on the glass substrate 10, the gate electrode 23 and the gate wire 24. In this embodiment, an SiH₄-NH₃-N₂-based mixed gas is used as a discharge gas.

Next, by using the high-frequency sputtering method, an n-type oxide semiconductor layer 40 (active layer) with a thickness of about 100 nm is formed on the gate insulating film 30 by using an indium oxide-gallium oxide-zinc oxide (In₂O₃:Ga₂O₃:ZnO=about 70:27:3 wt%) target. This layer formation is conducted under the condition of an oxygen-to-argon ratio of about 10:90 (vol%) and a substrate temperature of about 200°C or less. This condition is a condition which does not allow the n-type oxide conductor layer 40 to be crystallized. As is apparent from the above, by using the n-type oxide semiconductor layer 40 as an active layer of a TFT, a TFT remains stable when electric current is flown. Therefore, the reflective TFT substrate is advantageously used for an organic EL apparatus which is operated under current control mode.
In addition, the energy gap of this n-type oxide semiconductor layer 40 was about 3.6 eV. By rendering the energy gap large, prevention of malfunction caused by light can be ensured.

In the indium oxide-gallium oxide-zinc oxide (In₂O₃:Ga₂O₃:ZnO=about 70:27:3 wt%) target used in the formation of the n-type oxide semiconductor layer 40, the amount of zinc oxide added may preferably be about 1 to 6 wt%, more preferably about 2 to 5 wt%. The reason therefor is as follows. If the amount of the zinc oxide is less than about 1 wt%, carrier density may not be lowered, and if the amount exceeds about 6 wt%, carrier density may not be lowered or resistance to an acid mixture may be lost without being crystallized.

Subsequently, by using the high-frequency sputtering method, an oxide conductor layer 50 is formed in a thickness of about 150 nm on the n-type oxide semiconductor layer 40 by using an indium oxide-zinc oxide-tin oxide (In₂O₃:ZnO:SnO₂=about 60:20:20 wt%) target. This layer formation is conducted under the condition of an oxygen-to-argon ratio of about 1:99 (vol%) and a substrate temperature which does not allow the oxide conductor layer 50 to be crystallized. By doing this, switching speed of a TFT can be increased, and durability of a TFT can be improved.
In addition, the energy gap of the oxide conductor layer 50 was about 3.2 eV. By rendering the energy gap large, prevention of malfunction caused by light can be ensured.
Meanwhile, in this embodiment, the oxide conductor layer 50 is formed between the n-type oxide semiconductor layer 40 and the metal layer 60. However, for example, if electric contact resistance between the n-type oxide semiconductor layer 40 and the metal layer 60 is low, the oxide conductor layer 50 may not necessarily be formed.

The indium oxide-tin oxide-zinc oxide (In₂O₃:SnO₂:ZnO=about 60:20:20 wt%) thin film used as the oxide conductor layer 50 in this embodiment is not crystallized even when heated at about 350°C. It is better not to crystallize the oxide conductor layer 50. Without crystallization, the oxide conductor layer 50 can be etched with an aqueous oxalic acid solution. In addition, with the above-mentioned composition, the oxide conductor layer 50 is not patterned with an etching method using an acid mixture even if it is not crystallized. That is, the oxide conductor layer 50 has selective etching properties; specifically, while it has resistance to an etching solution for patterning the metal layer 60 with an etching method (an acid mixture), it can be patterned with an etching method using an etching solution which does not affect the crystallized n-type oxide semiconductor layer 40 (an aqueous oxalic acid solution). Furthermore, it is important that the oxide conductor layer 50 has selective etching properties; specifically, it can be patterned with an etching method together with the non-crystallized n-type oxide semiconductor layer 40 using a predetermined etching solution (an aqueous oxalic acid solution) and can be patterned with an etching method using an etching solution to which the crystallized n-type oxide semiconductor layer 40 has resistance (an aqueous oxalic acid solution).
Measurement of an AC hall effect of the above-mentioned n-type oxide semiconductor layer 40 was conducted (measurement by using "RESITEST" (product name), manufactured by Toyo Technica Inc.). The results of the measurement were as follows: carrier density: 10⁺¹⁴/cm³, mobility: 30 cm²/V·sec. Measurement of an AC hall effect of the oxide conductor layer 50 was conducted. The results of the measurement were as follows: carrier density: 10⁺²⁰/cm³, mobility: 38 cm²/V·sec. In the meantime, materials for the n-type oxide semiconductor layer 40 and the oxide conductor layer 50 used in this embodiment are not limited to those mentioned above.

Subsequently, on the oxide conductor layer 50, Mo, Al and Mo are stacked in this order by the high frequency sputtering method, whereby a metal layer 60 formed of an Mo layer (film thickness: about 50 nm)/an Al layer (film thickness: about 200 nm/an Mo layer (film thickness: about 50 nm) is formed. Meanwhile, the metal layer 60 functions as a reflective metal layer of the reflective TFT substrate 1. Here, it is preferred that the reflectance of the metal layer 60 be 80% or more. By doing this, it is possible to provide a reflective TFT substrate 1 which is improved in luminance. Further, instead of the metal layer 60 formed of the Mo layer/the Al layer/the Mo layer, it is possible to use a thin film of a metal such as Ag and Au. Due to such a configuration, a larger amount of light can be reflected, resulting in improvement in luminance by reflected light.
Here, each of the Mo layers is used in order to decrease the contact resistance with the oxide conductor layer 50 and the metal layer-protecting oxide transparent conductor layer 70. Therefore, the Mo layer may not neccessarily be formed if the contact resistance is negligibly low.

Subsequently, on the metal layer 60, the metal layer-protecting oxide transparent conductor layer 70 is formed with a thickness of about 150 nm by using an indium oxide-zinc oxide (In₂O₃:ZnO=about 90:10 wt%) target. This layer formation is conducted under the condition of an oxygen-to-argon ratio of about 1: 99 (vol%). By doing this, not only the metal layer 60 can be prevented from corrosion but also the durability thereof can be improved. As a result, discoloration or other problems of the metal layer 60 as a reflective metal layer can be prevented, and disadvantages such as a decrease in reflectance of the metal layer 60 can be prevented. In addition, the metal layer-protecting oxide transparent conductor layer 70 is transparent. Therefore, since the amount of transmitted light is not decreased, a display apparatus improved in luminance can be provided. If the metal layer 60 is formed of a stable metal which does not require the metal layer-protecting oxide transparent conductor layer 70, the metal layer-protecting oxide transparent conductor layer 70 may not necessarily be formed.
Subsequently, a second resist 71 is stacked on the metal layer-protecting oxide transparent conductor layer 70 (Step S2).

Then, as shown in FIG. 4(b), the second resist 71 is formed into a predetermined shape by using the second half-tone mask 72 and by half-tone exposure (Step S3 in FIG. 1). The second resist 71 is formed into such a shape that it covers the upper part of the gate electrode 23, a source electrode 63, a drain electrode 64, a source wire 65, a drain wire 66 and a pixel electrode 67, and part of the second resist 71 covering the upper part of a channel part 41 is rendered thinner than other parts due to a half-tone mask part 721.

FIG. 5 is a schematic view for explaining treatment using a second half-tone mask in the method for producing a reflective TFT substrate according to one embodiment of the invention, in which (a) is a cross-sectional view after second etching; and (b) is a cross-sectional view after reformation of a second resist.
In FIG. 5(a), as the second etching, the metal layer-protecting oxide transparent conductor layer 70 and the metal layer (Mo/Al/Mo) 60 are patterned simultaneously by an etching method using the second resist 71 and PAN. Further, the oxide conductor layer 50 and the n-type oxide semiconductor layer 40 are patterned simultaneously by an etching method by using the second resist 71 and an aqueous oxalic acid solution, whereby the source wire 65, the drain wire 66 and the pixel electrode 67 are formed as desired (Step S4 in FIG. 1).
No gap separating the source electrode 63 and the drain electrode 64 is formed by the above-mentioned second etching. However, part of the outline of the source electrode 63 and the drain electrode 64 is formed.

Then, as shown in FIG. 5(b), the above-mentioned second resist 71 is reformed (Step S5 in FIG. 1). That is, as shown in FIG. 5(b), of the second resist 71, part above the channel part 41 which is rendered thinner than other parts due to half-tone exposure is removed through an ashing process, whereby the second resist 71 is reformed (Step S5 in FIG. 1).

Next, treatment for forming the source electrode 63 and the drain electrode 64 will be explained with reference to the drawing.
FIG. 6 is a schematic view for explaining treatment using a second half-tone mask in the method for producing a reflective TFT substrate according to one embodiment of the invention, in which (a) is a cross-sectional view after third etching; and (b) is a cross-sectional view after peeling off of a second resist.
In FIG. 6(a), first, the metal layer-protecting oxide transparent conductor layer 70 and the metal layer 60 above the gate electrode 23 are patterned by an etching method using the reformed second resist 71 and PAN. Here, the oxide conductor layer 50 is not patterned with an etching method since it has resistance to PAN even in the non-crystallized state.

Next, the n-type oxide semiconductor layer 40 is crystallized by heating. Heating is conducted at a temperature of about 200°C or higher but not exceeding about 300°C. By doing this, while the n-type oxide semiconductor layer 40 has resistance to an aqueous oxalic acid solution due to crystallization, the oxide conductor layer 50 is patterned with an etching method using an aqueous oxalic acid solution since it is not crystallized.
Subsequently, the oxide conductor layer 50 above the gate electrode 23 is selectively patterned by an etching method using the reformed second resist 71 and an aqueous oxalic acid solution, whereby the source electrode 63 and the drain electrode 64 are formed (Step S6 in FIG. 1). In this case, the crystallized n-type oxide semiconductor layer 40 is not damaged since it has resistance to an aqueous oxalic acid solution. In addition, stable semiconductor performance can be attained due to crystallization.
The channel part 41 is formed in the n-type oxide semiconductor layer 40 above the gate electrode 23 by the above-mentioned patterning with an etching method. Therefore, the reflective TFT substrate 1 is called as a channel etching -type reflective TFT substrate.

Subsequently, as shown in FIG. 6(b), all of the reformed second resist 71 is removed through an ashing process. As a result, the metal layer-protecting oxide transparent conductor layer 70 formed above the source electrode 63, the drain electrode 64, the source wire 65, the drain wire 66 and the pixel electrode 67 is exposed (see FIG. 7). The drain electrode 64, the channel part 41, the source electrode 63, the source wire 65 and the pixel electrode 67 shown in FIG. 6(b) are cross-sectional views taken along line C-C in FIG. 7. The drain wire 66 shown in FIG. 6(b) is a cross-sectional view taken along line D-D in FIG. 7.

As shown in FIG. 1, a protective insulating film 80 and a third resist 81 are stacked in this order on the gate insulating film 30 and the n-type oxide semiconductor layer 40, which are exposed, as well as on the metal layer-protecting oxide transparent conductor layer 70 formed on the source wire 65, the drain wire 66, the source electrode 63, the drain electrode 64 and the pixel electrode 67 (Step S7), and the third resist 81 is formed into a predetermined shape by using a third mask 82 (Step S8).
Next, treatment using the third mask 82 will be explained.

### (Treatment using a third mask)

FIG. 8 is a schematic view for explaining treatment using a third mask in the method for producing a reflective TFT substrate according to one embodiment of the invention, in which (a) is a cross-sectional view after the formation of a protective insulating film/the application of a third resist; and (b) is a cross-sectional view after exposure/development.
In FIG. 8(a), the protective insulating film 80, which is a silicon nitride (SiNₓ) film, is deposited in a thickness of about 200 nm by the glow discharge CVD (Chemical Vapor Deposition) method on the reflective TFT substrate 1 on which the channel part 41 is formed. In this embodiment, an SiH₄-NH₃-N₂-based mixed gas is used as a discharge gas. Subsequently, the third resist 81 is stacked on the protective insulating film 80 (Step S7).

Then, as shown in FIG. 8(b), the third resist 81 is formed into a predetermined shape by using the third mask 82 (Step S8). The third resist 81 is formed into such a shape that it covers the entire protective insulating film 70, except for above the pixel electrode 67, the drain wire pad 68 and the gate wire pad 25.

FIG. 9 is a schematic view for explaining treatment using a third mask in the method for producing a reflective TFT substrate according to one embodiment of the invention, in which (a) is a cross-sectional view after fourth etching; and (b) is a cross-sectional view after peeling off of a third resist.
Next, as shown in FIG. 9(a), as a fourth etching, the protective insulating film 80 on the pixel electrode 67 and the drain wire pad 68, well as the protective insulating film 80 and the gate insulating film 30 on the gate wire pad 25 are patterned by a dry etching method using the third resist 81 and an etching gas (CHF (CF₄, CHF₃ gas, or the like) to expose the pixel electrode 67, the drain wire pad 68 and the gate wire pad 25 (Step S9 in FIG. 1) . That is, the pixel electrode 67, the drain wire pad 68 and the gate wire pad 25 are exposed through openings 671, 681 and 251 formed by patterning with a dry etching method.

Then, the third resist 81 is removed through an ashing process. As a result, as shown in FIG. 10, the protective insulating film 80 except for above the pixel electrode 67, the drain wire pad 68 and the gate wire pad 25 is exposed on the substrate 10. The drain electrode 64, the channel part 41, the gate electrode 23, the source electrode 63, the source wire 65 and the pixel electrode 67 shown in FIG. 9(b) are cross-sectional views taken along line E-E in FIG. 10. The drain wire pad 68 shown in FIG. 9(b) is a cross-sectional view taken along line F-F in FIG. 10. The gate wire pad 25 is a cross-sectional view taken along line G-G in FIG. 10.

As is apparent from the above, according to the method for producing the reflective TFT substrate 1 in this embodiment, manufacturing cost can be significantly reduced by decreasing the number of steps in the production process. Further, since the upper part of the n-type oxide semiconductor layer 40 constituting the channel part 41 is protected by the protective insulating film 80, the reflective TFT substrate 1 can be operated stably for a prolonged period of time. In addition, normally, the n-type oxide semiconductor layer 40 is formed only at predetermined positions (predetermined positions corresponding to the channel part 41, the source wire 65, the drain wire 66, the source electrode 63, the drain electrode 64 and the pixel electrode 67). Therefore, concern for occurrence of interference of the gate wires 24 (crosstalk) can be eliminated. Further, since the protective insulating film 80 is formed, an organic EL apparatus can be obtained readily by providing organic EL materials, electrodes and protective films on the reflective TFT substrate 1.

Meanwhile, in this embodiment, on the glass substrate 10, the thin film for a gate electrode/a gate wire 20 (including the metal layer-protecting oxide transparent conductor layer 26) and the first resist 21 are stacked. Then, the gate insulating film 30, the n-type oxide semiconductor layer 40, the oxide conductor layer 50, the metal layer 60, the metal layer-protecting oxide transparent conductor layer 70 and the second resist 71 are stacked. Further, the protective insulating film 80 and the third resist 81 are stacked. The stacking configuration is, however, not limited thereto. For example, these layers may be stacked with other layers being interposed therebetween. Here, "other layers" mean, for example, layers which do not impair the functions or the effects of this embodiment or layers which allow other functions or effects to be exhibited.

### [One embodiment of a reflective TFT substrate]

The invention is also advantageous as an invention of the reflective TFT substrate 1.
As shown in FIG. 9(b) and FIG. 10, the reflective TFT substrate 1 according to this embodiment comprises the glass substrate 10, the gate electrode 23, the gate wire 24, the gate insulating film 30, the n-type oxide semiconductor layer 40 and the metal layer 60.
The gate electrode 23 and the gate wire 24 are formed above the glass substrate 10. The gate insulating film 30 are formed above the glass substrate 10, the gate electrode 23 and the gate wire 24. The n-type oxide semiconductor layer 40 is formed at least above the gate electrode 23, as well as above the gate insulating film 30. The metal layer 60 is formed on the n-type oxide semiconductor layer 40 with the channel part 41 interposed therebetween.
That is, by providing the n-type oxide semiconductor layer 40 as an oxide layer and by using the n-type oxide semiconductor layer 40 as an active layer of a TFT, a TFT remains stable when electric current is flown. Therefore, the reflective TFT substrate 1 is advantageously used for an organic EL apparatus which is operated under current control mode.

Further, in the reflective TFT substrate 1, the metal layer 60 functions as the source wire 65, the drain wire 66, the source electrode 63, the drain electrode 64 and the pixel electrode 67. That is, by the manufacturing method according to the above-mentioned embodiment, the reflective TFT substrate 1 can be produced by using three masks (the first mask 22, the second half-tone mask 72 and the third mask 82). Therefore, since the production steps are reduced, production efficiency can be improved and manufacturing cost can be decreased. In addition, since the electric resistance of each wire 65 and 66 and each electrode 63 and 64 can be decreased, not only reliability can be improved but also a decrease in energy efficiency can be suppressed.

Further, in the reflective TFT substrate 1, the upper part of the reflective TFT substrate 1 is covered by the protective insulating film 80, and, at positions corresponding to each pixel electrode 67, the drain wire pad 68 and the gate wire pad 25, the protective insulating film 80 has openings 671, 681 and 251 for exposing the pixel electrode 67, the drain wire pad 68 and the gate wire pad 25. That is, normally, the upper part of the reflective TFT substrate 1 except for above the pixel electrode 67, the drain wire pad 68 and the gate wire pad 25, which are exposed, is entirely covered by the protective insulating film 80. Due to such a configuration, since the upper part of the n-type oxide semiconductor layer 40 constituting the channel part 41 is protected by the protective insulating film 80, the reflective TFT substrate 1 can be operated stably for a prolonged period of time. Further, the reflective TFT substrate 1 is provided with the protective insulating film 80. As a result, it is possible to provide the reflective TFT substrate 1 capable of producing readily a display means or an emitting means utilizing a liquid crystal, an organic EL material or the like.

Further, the reflective TFT substrate 1 has a configuration in which the oxide conductor layer 50 is formed between the n-type oxide semiconductor layer 40 and the metal layer 60. Due to such a configuration, switching speed of a TFT can be increased, and durability of a TFT can be improved.
Further, in the reflective TFT substrate 1, the metal layer 60 has a reflectance of 80% or more. By doing this, a reflective TFT substrate improved in luminance can be provided. Here, it is preferred that the metal layer 60 be formed of a thin film composed of aluminum, silver or gold or an alloy layer containing aluminum, silver or gold. Due to such a configuration, a larger amount of light can be reflected, whereby the luminance by the reflected light can be improved.

In addition, the reflective TFT substrate 1 has a metal layer-protecting oxide transparent conductor layer 26 on the gate electrode 23 and the gate wire 24, which are composed of a metal thin film. By doing this, the metal surface can be prevented from being exposed when the opening 251 for the gate wire pad 25 is formed, whereby connection reliability can be improved.
Further, the reflective TFT substrate 1 has the metal layer-protecting oxide transparent conductor layer 70 on the metal layer 60 as a reflective layer. Due to such a configuration, not only corrosion of the metal layer 60 can be prevented, but also durability can be improved. Further, discoloration or other problems of the metal layer 60 as a reflective layer can be prevented, and hence, disadvantages such as a decrease in reflectance of the reflective layer can be prevented. In addition, since the metal layer-protecting oxide transparent conductor layer is rendered transparent, the amount of transmitted light is not decreased. As a result, a display apparatus improved in luminance can be provided.

Further, in the reflective TFT substrate 1, the n-type oxide semiconductor layer 40 is formed at predetermined positions corresponding to the channel part 41, the source wire 65, the drain wire 66, the source electrode 63, the drain electrode 64 and the pixel electrode 67.
By doing this, since the n-type oxide semiconductor layer 40 is formed only at the predetermined positions, concern for occurrence of interference of the gate wires 24 (crosstalk) can be eliminated.
Further, in the reflective TFT substrate 1, the n-type oxide semiconductor layer 40 has an energy gap of about 3.0 eV or more. By rendering the energy gap 3. 0 eV or more, malfunction caused by light can be prevented. Normally, the energy gap may be 3.0 eV or more, preferably about 3.2 eV or more, and more preferably about 3.4 eV or more. If the reflective TFT substrate 1 is provided with the oxide conductor layer 50, the oxide conductor layer 50 may have an energy gap of about 3.0 eV or more. By doing this, similar effects can be obtained.

As mentioned hereinabove, the reflective TFT substrate 1 of this embodiment can significantly reduce manufacturing cost by decreasing the steps in the production. Further, since the upper part of the n-type oxide semiconductor layer 40 constituting the channel part 41 is protected by the protective insulating film 80, the reflective TFT substrate 1 can be operated stably for a prolonged period of time. In addition, due to the formation of the protective insulating film 80, an organic EL apparatus can be obtained easily by providing organic EL materials, electrodes and protective films on the reflective TFT substrate 1. Further, since the n-type oxide semiconductor layer 40 is formed only at predetermined positions, concern for occurrence of interference of gate wires 24 (crosstalk) can be eliminated.

The reflective TFT substrate and the method for producing the reflective TFT substrate of the invention are explained hereinabove with reference to a preferable embodiment. However, the reflective TFT substrate and the method for producing the reflective TFT substrate of the invention are not limited to the above-mentioned embodiment, and, it is needless to say that various modifications can be made within the scope of the invention.
For example, the material for the n-type oxide semiconductor layer 40 or the material for the oxide conductor layer 50 used in the above embodiment is not limited to those mentioned above.
That is, as the material for the n-type oxide semiconductor layer 40, indium oxide, zinc oxide, tin oxide, indium oxide-zinc oxide, zinc oxide-tin oxide, indium oxide-zinc oxide-tin oxide, indium oxide-zinc oxide-gallium oxide, or those obtained by adding an insulating transparent oxide to these oxides can be used. Specific examples of the insulating transparent oxide include yttrium oxide, titanium oxide, zirconium oxide, hafnium oxide, niobium oxide, tantalum oxide, boron oxide, aluminum oxide, silicon oxide, germanium oxide and an oxide of a lanthanoide-based element.

If the above-mentioned oxides are used in the n-type oxide semiconductor layer 40, it is important to make the carrier density thereof 10⁺¹⁷/cm³ or less. In this case, it is preferred that film formation be performed in the presence of a large amount of oxygen or that heat treatment be performed in the presence of oxygen. By doing this, carriers can be decreased by oxygen deficiency. In addition, in order to decrease carrier density, for example, it is preferred that zinc oxide be added to indium oxide or that indium oxide be added to tin oxide. By doing this, carriers can be decreased by valence electron control. Combination of these methods also enables carriers to be decreased effectively.
Specific examples of the oxide conductor layer 50 include indium oxide, zinc oxide, tin oxide, indium oxide-zinc oxide, zinc oxide-tin oxide, indium oxide-zinc oxide-tin oxide and the like. If the above-mentioned oxides are used for the oxide conductor layer 50, it is important to render the carrier density 10⁺²⁰/cm³ or more.

### INDUSTRIAL APPLICABILITY

The reflective TFT substrate and the method for producing the reflective TFT substrate of the invention are not limited to a reflective TFT substrate and a method for producing a reflective TFT substrate used in LCD (liquid display) apparatuses or organic EL display apparatuses. The invention can also be applied to a reflective TFT substrate or a method for producing a reflective TFT substrate which are used for display apparatuses other than LCD (liquid crystal display) apparatuses or organic EL display apparatuses, or to a reflective TFT substrate or a method for producing a reflective TFT substrate which are used for other applications.

## Claims

1. A reflective TFT substrate comprising:
a substrate;
a gate electrode and a gate wire formed above the substrate;
a gate insulating film formed above the substrate, the gate electrode and the gate wire;
an oxide layer formed above the gate electrode, and above the gate insulating film;
a metal layer formed above the oxide layer with a channel part interposed therebetween; and
a pixel electrode which contacts a source/drain electrode, wherein
the metal layer functions at least as the pixel electrode and the source/drain electrode which contacts the pixel electrode.

2. The reflective TFT substrate according to claim 1, wherein an oxide conductor layer is formed between the oxide layer and the metal layer.

3. The reflective TFT substrate according to claim 1 or 2, wherein the reflectance of the metal layer is 80% or more.

4. The reflective TFT substrate according to any one of claims 1 to 3, wherein the metal layer is formed of a thin film of aluminum, silver or gold, or an alloy layer containing aluminum, silver or gold.

5. The reflective TFT substrate according to any one of claims 1 to 4, wherein the reflective TFT substrate is provided with a metal layer and/or a metal thin film, and has a metal layer-protecting oxide transparent conductor layer for protecting the metal layer and/or the metal thin film.

6. The reflective TFT substrate according to any one of claims 1 to 5, wherein the upper part of the reflective TFT substrate is covered with a protective insulating film, and the protective insulating film has openings at positions corresponding to each of the pixel electrode, a source/drain wire pad and a gate wire pad.

7. The reflective TFT substrate according to any one of claims 1 to 6, wherein the oxide layer is an n-type oxide semiconductor layer.

8. The reflective TFT substrate according to any one of claims 1 to 7, wherein the oxide layer is formed at predetermined positions corresponding to the channel part, a source wire, a drain wire, a source electrode, a drain electrode and the pixel electrode.

9. The reflective TFT substrate according to any one of claims 1 to 8, wherein the oxide layer has an energy gap of 3.0 eV or more.

10. A method for producing a reflective TFT substrate comprising the steps of:
forming a gate electrode and a gate wire above a substrate by using a first mask;
stacking a gate insulating film, an oxide layer, a metal layer and a second resist above the substrate, the gate electrode and the gate wire, and forming the second resist into a predetermined shape by half-tone exposure;
patterning the metal layer and the oxide layer by an etching method using the second resist to form a source wire, a drain wire and a pixel electrode;
after reforming the second resist, selectively patterning the metal layer above the gate electrode by an etching method using the reformed second resist to form a source electrode and a drain electrode;
stacking a protective insulating film and a third resist above the gate insulating film and the oxide layer, which are exposed, as well as above the source wire, the drain wire, the source electrode, the drain electrode and the pixel electrode, and forming the third resist into a predetermined shape by using a third mask; and
patterning the protective insulating film above the pixel electrode and a source/drain wire pad, as well as the protective insulating film and the gate insulating film above a gate wire pad by an etching method using the third resist to expose the pixel electrode, the source/drain wire pad and the gate wire pad.

11. The method for producing a reflective TFT substrate according to claim 10, wherein an oxide conductor layer is formed between the oxide layer and the metal layer.

12. The method for producing a reflective TFT substrate according to claim 10 or claim 11, wherein a metal layer-protecting oxide transparent conductor layer is stacked above the metal layer.

13. The method for producing a reflective TFT substrate according to any one of claims 10 to 12, wherein a metal layer-protecting oxide transparent conductor layer is stacked above the gate electrode and the gate wire.
